# EUROPÄISCHE PATENTANMELDUNG

(11) **EP 0 748 880 A2**
(43) Veröffentlichungstag der Anmeldung: **18.12.1996**
(21) Anmeldenummer: 96108290.6
(22) Anmeldetag: 24.05.1996
(51) Int. Cl.: C23C 14/02, C23C 28/00, C23C 14/06

(54) **Verfahren zur Herstellung einer haftfesten und korrosionsbeständigen Hartstoffschicht**

(30) Priorität: 29.05.1995 DE 19518981
(71) Anmelder: VTD-VAKUUMTECHNIK DRESDEN GMBH, D-01257 Dresden (DE); JADO Design Armatur und Beschlag AG, 63322 Rödermark (DE)
(72) Erfinder: Woeste, Hans-Peter, 64832 Babenhausen (DE); Schulze, Dietmar, Dr.rer.nat., 01474 Schönfeld (DE); Wilberg, Rüdiger, 01259 Dresden (DE)
(74) Vertreter: Pätzelt, Peter, Dipl.-Ing. Patentanwalt

(57) **Zusammenfassung**

Die Erfindung betrifft eine Verfahren zur Herstellung einer haftfesten und korrosionsbeständigen Hartstoffschicht auf einem Substrat mit einer Ni/Cr-Beschichtung, bei dem die Hartstoffschicht mit einem plasmagestützten physikalischen Vakuumbeschichtungsverfahren abgeschieden wird, wobei die Substrate in einer ersten Temperung aufgeheizt werden bis vorhandene Wasserkondensate von den Oberflächen abgedampft sind und in einer zweiten Temperung der eingeschlossene Wasserstoff ausgetrieben wird, daß danach die Temperatur abgesenkt wird und nach einer Ionenbeschußreinigung eine Metallschicht und eine korrosionsbeständige Hartstoffschicht abgeschieden wird, wobei die Temperatur unterhalb der Temperatur der zweiten Temperung gehalten wird.

## Beschreibung

Die Erfindung betrifft eine Verfahren zur Herstellung einer haftfesten und korrosionsbeständigen Hartstoffschicht auf einem Substrat mit einer Ni/Cr-Beschichtung nach dem Oberbegriff des Anspruchs 1. Die Substrate können dabei aus unterschiedlichen Grundmaterialien bestehen. In der Praxis werden am häufigsten Eisen-Werkstoffe, Messing oder andere gut formbare metallische Materialien eingesetzt.

Der Zweck der Beschichtung besteht dabei insbesondere darin, die Substrate mit haftfesten, korrosionsschützenden und funktionellen wie dekorativen Deckschichten zu versehen. Anwendungsgebiete sind z. B. Gebrauchsgegenstände, wie Uhrengehause, Brillengestelle, Eßbestecke, Modeschmuck oder Wasser-Armaturen, die mit einer dekorativen, korrosionsbeständigen und abriebfesten Deckschicht versehen werden sollen. Bei bestimmten Anwendungen kann auch ein geringer Reibungsfaktor von Interesse sein.

Nach den Stand der Technik werden neben der chemischen Schichtabscheidung verbreitet physikalische plasmagestützte Vakuumbeschichtungsverfahren (PVD) für die Herstellung der genannten Schichten angewendet. Derartige Schichten werden vorzugsweise reaktiv als Hartstoffschichten abgeschieden und sind bekanntermaßen selbst hervorragend korrosionsbeständig und von hoher Härte. Die Korrosionschutzwirkung dieser Schichten ist dagegen fast immer ungenügend, da die meist nur wenige µm dicken Schichten nicht hinreichend lochfrei und dicht abgeschieden werden können.

Das hat seine Ursachen darin, daß die Schichten bei der Abscheidung stengelförmig aufwachsen und Störungen in der Üblicherweise relativ rauhen Unterlage ein perfektes, dichtes Zusammenwachsen der Schicht verhindern.
Somit wird kein komplett geschlossener Überzug erzielt, der den korrosiven Medien auf Dauer standhält. Vielfältige Versuche, die Dichte der physikalisch, plasmagestützt abgeschiedenen Schicht zu erhöhen, führten bislang zu keinem ausreichenden Erfolg. Wenn bei höheren Substrattemperaturen die abgeschiedenen Schichten perfekter werden, dann steht dem in zunehmendem Maße eine unerwünschte Erhöhung der Korngrößen in der Schicht gegenüber.

Nach dem Stand der Technik ist es heute allgemein üblich, vor der Abscheidung einer funktionellen und/oder dekorativen Deckschicht eine gesonderte korrosionsschützende Zwischenschicht abzuscheiden. Naheliegend ist es, als eine solche Schicht in bekannter Weise eine kostengünstige galvanische Ni/Cr-Schicht abzuscheiden. Gerade diese Lösung führte jedoch bisher zu keinem brauchbaren Ergebnis. Die nachfolgend plasmagestützt abgeschiedenen Deckschichten platzen nach einer gewissen Zeit regelrecht vom Substrat ab.

In der CH 657 154 wird ein goldfarbener, dekorativer Überzug für Gegenstände aus einem wärmebeständigen Grundmaterial angegeben, der aus einer Zwischenschicht aus Zirkonnitrid von 0,1 bis 2 µm Dicke und einer Gold enthaltenden Deckschicht von 0,01 bis 1 µm besteht. Das Grundmaterial ist dabei beispielhaft mit einer Chrom- und/oder Nickelschicht versehen. Die Erfindung wird für aufwendige Beschichtungen angewendet, bei denen die Schicht wieder entfernt werden kann, wenn die Beschichtung nicht erfolgreich war.

Die DE 38 09 139 gibt ein Verfahren an, bei dem die Probleme mit Ni/Cr-Zwischenschichten durch die Anwendung von Ni/NiPd-Schichten vermieden werden. Das Problem dabei ist, daß derartige Schichten wesentlich teuerer sind als bekannte Ni/Cr-Schichten.

In der DE-OS 30 06 308 wird ein Verfahren angegeben, bei dem der Gegenstand bzw. dessen Oberfläche, zwecks Entfernung des Wasserstoffs lediglich aus dem Oberflächenbereich des Grundmaterials, vor der eigentlichen Beschichtung mit einer kommerziell verwertbaren Hartstoffschicht über eine Zeitdauer von 2 bis 24 Stunden auf 100°C bis 400°C erhitzt wird. Dabei wird davon ausgegangen, daß die Ursachen für den Ausfall der Hartstoffschichten im Wasserstoffgehalt in der Oberfläche, d. h. in der Chromschicht und dabei in den physikalisch-chemischen Eigenschaften des galvanischen Chromabscheideprozesses, zu suchen sind.

Offensichtlich nachteilig ist, daß dieses Verfahren wegen der teils hohen Temperaturen und vorallem der langen Temperzeiten für eine Serienproduktion nicht vertretbar ist. Es ist auch zu befürchten, daß der beschriebene Temperprozeß z. B. bei der Anwendung von Messing-Substraten, zur Zerstörung oder unerwünschten Beeinflussung des Grundmaterials und/oder zur Oxydation der Chromoberfläche führt. Dadurch ist eine praktische Anwendung des Verfahrens für dekorative Anwendung zweifelhaft.

Der Erfindung liegt als Aufgabe zugrunde, ein industriell vorteilhaftes Verfahren zur Beschichtung eines Substrates mit einer haftfesten und funktionellen wie dekorativen Hartstoffschicht als Deckschicht anzugeben, bei dem die Korrosionsbeständigkeit des zu beschichtenden Substrates durch eine kostengünstige korrosionsschützende Ni/Cr-Beschichtung gewährleistet wird.

Die Erfindung löst die Aufgabe durch die im kennzeichnenden Teil des Anspruchs 1 genannten Merkmale. Weiterbildungen der Erfindung sind in den Unteransprüchen gekennzeichnet.

Gegenüber den bekannten Lösungen nach dem Stand der Technik wurde gefunden, daß die Beschichtung eines Substrates mit einer Ni/Cr-Beschichtung als Korrosionsschutzschicht mit einer funktionellen und/oder dekorativen Hartstoffschicht, entsprechend der Aufgabenstellung dieser Erfindung, nicht mit einzelnen Verfahrensschritten erzielt werden kann, sondern es muß vielmehr der Schichtaufbau sowie der gesamte Verfahrensablauf mit all seinen Einzelschritten, wie beansprucht, aufeinander abgestimmt werden.

Dabei ist innerhalb eines Beschichtungszyklusses die Beherrschung des Gashaushaltes in der gesamten Beschichtungskammer von besonderer Bedeutung. Bevor der Anteil des Wasserstoffs in der Oberflächenzone der Substrate erfindungsgemäß beeinflußt wird, ist es erforderlich die Beschichtungskammer von molekularen Wasserstoff und Wasserdampf zu befreien.

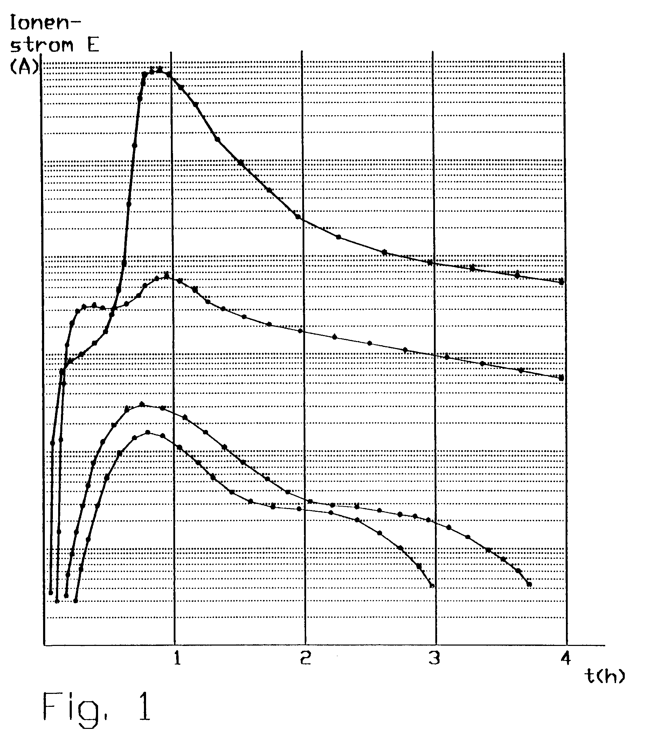

In Figur 1 ist der prinzipielle Verlauf des Gashaushaltes in einer Beschichtungskammer dargestellt, wie er ermittelt wurde, wenn Türriegel aus geschmiedeten Messing mit einer galvanischen Ni/Cr-Korrosionsschutzschicht getempert werden. Die Entgasung der gesamten Beschichtungskammer mit allen Einbauten und Substraten beginnt sofort nach Erreichen einer Temperatur von ca. 200°C an den einzelnen Oberflächen. Das Innere der Substrate hat dabei aufgrund der Wärmekapazität der Substrate eine noch wesentlich geringere Temperatur.

Die Hauptkomponente der Gasabgabe ist der molekulare Wasserstoff - Kurve 1 -, gefolgt vom Wasserdampf - Kurve 2.

Daran schließen sich Kohlenwasserstoffe - Kurve 3 und 4 - mit deutlich geringerer Menge an. Letztere stammen offensichtlich von Bearbeitungsrückständen auf den Substraten.

Bei konstanter Oberflächentemperatur steigt die Entgasungsgeschwindigkeit innerhalb weniger Minuten steil an, bleibt für ca. 10 min auf einem hohen Wert und fällt danach sehr langsam innerhalb von mehr als 3 Stunden auf den Anfangswert ab.

Wenn der Anteil der Wasserstoff-Komponente, wie auch anderer Komponenten im Restgas, nach Überschreiten eines Maximums wieder abfällt, dann wird darauf geschlossen, daß die entgasten Komponenten sehr oberflächennah verankert und quantitativ begrenzt waren.

Im Hinblick auf das Fehlen einer direkten Beziehung des Verlaufes des Wasserstoff-Anteils zu den Kohlenwasserstoff-Anteilen wird angenommen, daß der Wasserstoff nicht als Bruchstück gekrackte CₓH_{y}-Verbindungen entsteht, sondern in der galvanischen Aufbringung der Ni-Schicht aus einer Ammoniak enthaltenden Lösung von Nickelammoniumsulfat begründet ist. Das zeigt auch der dem H₂ exakt folgende Verlauf der NH₄-Bruchstücke.

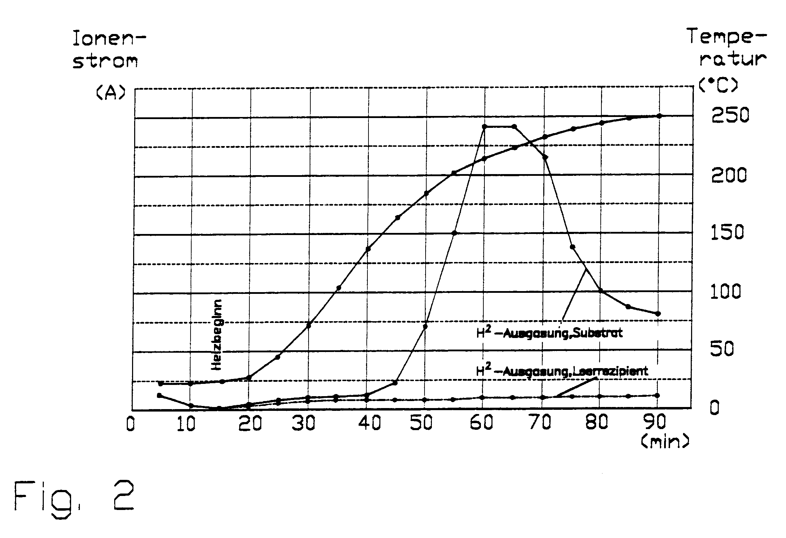

Figur 2 zeigt den Gesamtverlauf der Gasabgabe, wobei der Beginn bei ca. 130°C Oberflächentemperatur liegt und der Prozeß nach ca. 15 min. beendet ist. Dabei ist es entscheident, ob die Erwärmung der Substrate durch Strahlungsheizung oder durch Ladungsträgerbeschuß im Plasma einer Gasentladung erfolgt. Im ersten Fall wird mit einer Stahlungsheizung die Wasserbedeckung der Oberflächen der Substrate sowie der Kammerwand und -einbauten als Wasserdampf abgegeben, der mit hoher Geschwindigkeit durch die Üblichen Vakuumpumpen abgepumpt wird. Im zweiten Fall wird der Wasserdampf durch Ladungsträgerbeschuß sofort in H₂ und O₂ dissoziiert mit der Folge, daß die Konzentration des H₂ stark ansteigt. Die Ursache für den starken Anstieg liegt darin begründet, daß die Saugleistung für H₂ bei allen Hochvakuumpumpen äußerst niedrig ist. Eine auch nur kurzfristige hohe Konzentration des H₂ in der Beschichtungskammer ist dabei für alle folgenden Prozesse äußerst nachteilig.

Erfindungsgemäß wird somit beansprucht, daß vor der Entfernung des Wasserstoffs aus dem oberflächennahen Bereich der Substrate erst mit einer leistungsstarken Strahlungsheizung eine ausreichende Desorption des Wasserdampfes von den Substratoberflächen und allen Oberflächen der Wand der Beschichtungskammer und -einbauten durchgeführt wird.

Erst nach Abschluß der Desorption des Wasserdampfes wird die Substrattemperatur zum Zwecke des Austreibens des Wasserstoffs wie beansprucht weiter erhöht. Vorteilhaft ist es dabei, eine Gasentladung zu zünden und eine effektive Aufheizung der Substrate durch Beschuß mit Elektronen aus dem Gasentladungsplasma durchzuführen.

Mit der zweiten Phase der Temperung, z. B. mittels Elektronenbeschuß, wird dann in effektiver Weise der Wasserstoff mindestens aus der oberflächennahen galvanischen Chromschicht ausgetrieben.

Als Gasentladung wird in vorteilhafter Weise eine wirksame Niedervoltbogenentladung eingesetzt. Beispielsweise ist ein Verfahren und eine Einrichtung zur plasmagestützten Beschichtung von Substraten mit einer Hohlkatoden-Bogenentladung in der DE 42 28 499 C1 beschrieben. Unter Anwendung einer derartigen Einrichtung ist es erforderlich, die Verfahrensführung bei der vorliegenden Erfindung dahingehend zu verändern, daß bei der Beschichtung die temperaturempfindlichen galvanisch mit Ni/Cr beschichteten Substrate nicht überlastet werden. Dazu wird eine hohe Plasmadichte erzeugt und gleichzeitig die Energie der auf die Oberfläche auftreffenden Ionen niedrig gehalten. Die hohe Plasmadichte wird durch einen hohen Entladungsstrom der Niedervoltbogenentladung erzeugt und die Ionenenergie zum Beschuß der Substrate wird durch eine Vorspannung des Substrates gerade so eingestellt, daß man einerseits eine merkliche Abstäuberate erhält, andererseits aber die Temperatur am Ende der zweiten Phase der Temperung im beanspruchten Rahmen bleibt. Derart erfolgt eine effektive Oberflächenreinigung durch intensives Abstäuben von unerwünschten Belägen, sowie die mindestens teilweise Entfernung der Chromoxidschicht.

Es hat sich dabei als sehr zweckmäßig erwiesen, die Substrat-Vorspannung zu Beginn des Reinigungsprozesses langsam zu erhöhen und somit die Gefahr der Schädigung von polierten Substratoberflächen durch Bogenentladungen, die sich an verunreinigten Stellen ausbilden können, zu verringern.

Andere Verfahren zur Ionenbeschußreinigung, wie die Gleichstrom-Glimmentladung oder die magnetronunterstützte Entladung, sind meist ungeeignet, da diese Entladungen üblicherweise bei einem Druck von 10⁻² bis 10 mbar und Substrat-Vorspannungen von mehr als -400 V brennen müssen, um eine nennenswerte Plasmadichte zu erzeugen. Bei einem derartig hohen Druck ist der Transportprozeß der z. B. abgestäubten Oxide, infolge der geringen freien Weglänge, behindert. Eine effektive Oxidabstäubung ist nicht erreichbar. Gleichzeitig ist durch die hohe Ionenenergie die Gefahr der Überhitzung der empfindlichen Teile, speziell an Kanten und Ecken, sehr hoch. An Bohrungen und Durchbrüchen treten infolge Hohlkatodenbildung bei hohen Drükken Probleme auf. Der Einsatz derartiger Entladungen für eine Beschichtung im Sinne der vorliegenden Aufgabenstellung ist nahezu ausgeschlossen.

Die allgemein bekannte Verfahrensweise, die in Anlagen mit kathodischen Bogenverdampfern zur Ionenbeschußreinigung eingesetzt wird, besteht darin, Metallionen, die aus der Verdampferquelle selbst stammen, mit hoher Energie von mehr als 1000 eV auf die Substratoberfläche zu beschleunigen und dort eine Abstäubung von Verunreinigungen zu erreichen. Wird diese Energie entsprechend unterschritten, dann erfolgt kein Abstäuben von Oberflächenteilchen, sondern ein Schichtaufbau, der bei der vorliegenden Aufgabe unerwünscht ist.

Während die beschriebene Ionenbeschußreinigung bei der Beschichtung z. B. von Werkzeugen aus Hartmetall oder thermisch hochbelastbaren Stählen unproblematisch ist und zu guten Ergebnissen führt, weil der Reinigungsprozeß mit einem meist vorteilhaften Ionenimplantationseffekt verbunden ist, ist die Ionenbeschußreinigung bei der vorliegenden Aufgabe, z. B. zur dekorativen Beschichtung temperaturempfindlicher Materialien, äußerst kompliziert. Der Beschuß der Substratoberflächen mit Ionen hoher Energie bringt zwangsläufig auch einen hohen Wärmeeintrag mit sich. Nach dem Stand der Technik wird das vermindert, indem die Ionenbeschußreinigung zur Abkühlung der Substrate unterbrochen wird. Wenn jedoch die Temperatur der Substrate relativ gering ist (<200°C), dann verläuft auch die Abkühlung sehr langsam und ist für den Verfahrensablauf zeitlich zu aufwendig und uneffektiv.

Darüberhinaus ist in technischen Vakuumanlagen immer die Möglichkeit einer unerwünscht hohen Konzentration von reaktiven Gasen gegeben. In den Pausenzeiten kann es dadurch schnell zu einer Wiederbelegung der frisch abgestäubten und stark reaktiven Oberflächen mit neuen Reaktionsprodukten, wie z. B. Oxiden, kommen.

Auch besteht die Gefahr, daß beim Betreiben von kathodischen Bogenverdampfern vom Target Tröpfchen geschmolzenen Materials emittiert werden und auf der Substratoberfläche auftreffen. Dadurch kann eine polierte Oberfläche in unakzeptabler Weise beschädigt werden.

Nach der zuvor beschriebenen Reinigung der Substratoberfläche, d. h. der bereits galvanisch abgeschiedenen Ni/Cr-Schicht, ist es erfindungsgemäß erforderlich, die Beschichtung in komplexer Abstimmung aufzubauen.

Sowohl die galvanisch abgeschiedene Ni/Cr-Schicht wie die nachfolgend abgeschiedene Hartstoff-Deckschicht, sind zu optimieren.

Die erste Ni-Schicht hat die Aufgabe, die mechanisch oder chemisch geglättete Oberfläche weiter einzuebnen und im wesentlichen den eigentlichen Korrosionschutz zu gewährleisten. Die darauf als nächste galvanisch abgeschiedene Cr-Schicht dient insbesondere als Schutz gegen das Anlaufen der Nickeloberfläche beim zwangsweise technologisch auftretenden Zwischenlagern der galvanisch beschichteten Teile vor dem Aufbringen der Hartstoffschicht und auch als weiterer Beitrag zum Korrosionschutz der Substrate.

Wenn die optimal aufgebrachten galvanischen Ni/Cr-Schichten in herkömmlicher Weise mit einem PVD-Verfahren beschichtet werden, wird überraschender Weise festgestellt, daß der Schichtaufbau bereits nach einem relativ kurzem Korrosionstest zerstört wird. Parallelversuche ohne PVD-Beschichtung zeigten dagegen, daß die galvanische Ni/Cr-Schicht dem gleichen Korosionstest standhält. Unter Anwendung der erfindungsgemäßen Verfahrensführung wird dagegen der Korrosionstest erfolgreich durchlaufen.

Die erfindungsgemäße Lösung beinhaltet eine PVD-Beschichtung, bei der, nach der galvanischen Ni/Cr-Schichtabscheidung und der bereits beschriebenen Reinigung der Substratoberflächen, zuerst eine metallische Zwischenschicht mit dem Metall, das auch zur Deckschichtbildung Verwendung findet, abgeschieden wird.

Wesentlich ist, daß die Beschichtung mit geringer Geschwindigkeit bei niedriger Substrat-Vorspannung erfolgt. Dabei kommt es offensichtlich zu einer vorteilhaften Verbindung der Metallschicht mit den CrOₓ-Resten auf der Cr-Oberfläche, die trotz Ionenbeschußreinigung noch verblieben sind. Dieser Effekt bewirkt eine wesentliche Verbesserung der Haftfestigkeit. Mit der niedrigen Substrat-Vorspannung wird erreicht, daß trotz der Beschichtung die Temperatur der Substratoberflächen gegenüber dem Ende der Phase der Elektronenstoßheizung deutlich abfällt. Alle Wärmequellen, wie Strahlungsquellen oder die thermische Wirkung der Niedervoltbogenentladung, sind mindestens gegenüber der Substratoberfläche unterbrochen.

Wenn mehrere Bogenverdampfer vorhanden sind, ist es auch möglich, mittels Blenden einen Teil des Dampf- und Ionenstromes zur Substratoberfläche abzusperren. Nicht vorteilhaft ist es, wenn eine oder mehrere Verdampfer erst später zugeschaltet werden. Dabei besteht die Gefahr, daß Verunreinigungen auf der Targetoberfläche auf die Substrate gelangen und dort zu unerwünschten Wirkungen führen.

Die Abscheidung mit der metallischen Zwischenschicht erfolgt unter Anwesenheit eines inerten Spülgases, z. B. Argon, bei einem Druck von ca 10⁻³mbar.

Abschließend wird die funktionelle und/oder dekorative Hartstoffschicht aufgebracht. Die Geschwindigkeit der Abscheidung wie die Substrat-Vorspannung müssen dazu erhöht werden, damit die verfahrenstypischen Reaktionen erzielt werden, wobei die Maximaltemperatur an der Substratoberfläche erfindungsgemäß konstant unterhalb der Temperatur bei der zweiten Temperung gehalten wird.

Die Beschichtung erfolgt üblicherweise reaktiv, d. h. es wird ein Reaktivgas, z. B. N₂ oder CₓH_{y}, bis zu dem für die Abscheidung erforderlichen Druck in die Beschichtungskammer eingelassen. Zusätzlich kann auch weiterhin das Spülgas eingelassen werden.

Als vorteilhaft hat sich erwiesen, wenn die Abscheidung der funktionellen und/oder dekorativen Hartstoffschicht derart durchgeführt wird, daß das übliche stengelförmige Kornwachstum unterbrochen oder gestört wird. Dazu können die Geschwindigkeit der Abscheidung, der Reaktivgasfluß und/oder die Substrat-Vorspannung gepulst oder moduliert werden. Beispielsweise kann zu diesem Zweck auch eine Anordnung dienen, bei der die Substrate zwischen bzw. um einzelne kathodische Bogenverdampfer rotieren wobei die Substrat-Vorspannung zwischen -80V und -150V liegt. Die ständig wechselnde Beschichtungsrichtung, die durch die Rotation am Substrat ständig wechselnde Plasmadichte sowie die rotationsmodulierte Änderung des Metall-zu-Gas-Verhältnisses am Substrat führt zu einem sandwichartigen Aufbau der korrosionschützenden Hartstoffschicht, ohne durchgehende Stengelstruktur. Bei impulsartiger Zuführung der Substrat-Vorspannung kann die Ionenenergie weiter erhöht werden, ohne daß der Temperatureintrag zu hoch wird.

Im Bedarfsfall kann auf die erste Hartstoffschicht auch eine zweite Hartstoffschicht aufgebracht werden. Das kann dann erforderlich sein, wenn die Farbe der Deckschicht, z.B. durch Zumischen weiterer Reaktivgaskomponenten, üblicherweise ein CₓH_{y}-Gas, entsprechend den Erfordernissen optimiert werden soll.

Von besonderer erfinderischer Bedeutung sind innerhalb des komplexen Verfahrensablaufes die unterschiedlichen Arbeitstemperaturen. Während in der Reinigungsphase bei der ersten Temperung mit einer niedrigeren Temperatur eine Dissoziation des an den Oberflächen kondensierten Wassers erfogt, wird bei der zweiten Temperung mit einer für das Grundmaterial und die galvanische Ni/Cr-Beschichtung maximal zulässigen Temperatur der Wasserstoff aus der oberflächennahen Zone ausgetrieben. Bei allen nachfolgenden Beschichtungsabschnitten wird dann die Temperatur der Substrate stets unterhalb der maximalen Temperatur bei der zweiten Temperung gehalten. Damit wird verhindert, daß erneut Wasserstoff aus tieferen Bereichen der galvanischen Beschichtung an die Oberfläche gelangen kann und dort zu Haftungsproblemen führt.

Die Erfindung soll nachstehend an einem Ausführungsbeispiel näher erläutert werden.
Substrate aus Messing, z. B. Wasser-Armaturen oder Türdrücker, sollen mit einer haftfesten, korrosionsbeständigen, abriebbeständigen und dekorativen Hartstoffschicht mit goldener Farbe beschichtet werden.

Auf die Messing-Substrate wird zuerst eine galvanische Schicht, bestehend aus einer 15 µm dicken Nickelschicht und darauf einer 0,3µm dicken Chromschicht, aufgebaut. Dabei soll die Nickelschicht vordergründig den Korrosionsschutz des beschichteten Teiles sichern und die Chromschicht die Nickelschicht vor dem nachteiligen Anlaufen der Oberfläche schützen.

Nachfolgend wird in einem zweiten gesonderten Beschichtungszyklus die Hartstoffschicht aufgebracht. In einer dazu benutzten üblichen Beschichtungskammer sind beispielsweise zwei kathodische Bogenverdampfer, eine Hohlkathodenbogen-Plasmaquelle, mehrere Strahlungsheizer, Inertgas- und Reaktivgaseinlässe, ein Evakuierungssystem und ein Drehkorb mit Mitteln zur Befestigung der Substrate vorhanden.

Die Beschichtungskammer wird zuerst auf einen Druck von 5x10⁻⁵mbar evakuiert. In der Folge werden zum Zwecke der ersten Temperung die Strahlungsheizer eingeschaltet. Dabei steigt mit der Temperatur auch der Druck in der Anlage auf ca. 5x10⁻⁴mbar. Nadem die Oberfläche der Substrate etwa eine Temperatur von 80°C erreicht hat, wird die Heizleistung reduziert und es stellt sich ein Kammerdruck von ca. 8x10⁻⁵mbar ein.

Danach wird zum Zwecke der zweiten Temperung durch die Kathode der Hohlkathoden-Plasma-quelle Argon bis zu einem Druck von 5⁻³mbar eingelassen und die Gasentladung gezündet. Die Bogenentladung brennt mit einer Stromstärke von 250 A zwischen der Hohlkathode und dem als Anode geschalteten Drehkorb mit den Substraten.

Nach ca. 5 min hat die Temperatur an der Substratoberfläche einen Wert von 205°C erreicht und wird über eine Zeitdauer von 3 min konstant gehalten.

Danach wird der Entladungsstrom der Gasentladung auf 150 A reduziert und vom Drehkorb als Anode auf eine gesonderte Elektrode geschaltet. In der Folge wird der Drehkorb über eine gesonderte Stromversorgung innerhalb von 10 min langsam von 0 auf -200V geregelt und über weitere 10 min konstant gehalten. Die Stromstärke der Gasentladung wird während dieser Zeit in Abhängigkeit von der Substratoberfläche und der Masse der Substrate derart eingestellt, daß sich eine Substratstromdichte von 0,5 bis 1,5 A/cm² einstellt. Die Substrattemperatur fällt dabei langsam derart ab, daß sich am Ende des Reinigungsprozesses ein Wert von 160°C einstellt. Danach wird die Hohlkathoden-Bogenentladung ausgeschaltet.
Zum Zwecke der eigentlichen Hartstoffbeschichtung werden danach die zwei kathodischen Bogenverdampfer mit Targets aus Zirkon in einer Argon-Atmosphäre mit 1⁻⁴mbar gezündet. Die Substrat-Vorspannung wird mit -60V eingestellt.

Nach ca. 2 min hat sich eine metallische Zirkon-Schicht mit einer Dicke von 0,05µm auf den Substraten abgeschieden. Die Substrattemperatur beträgt 145°C.

Darauf folgt nacheinander die Einstellung der Stromstärke der Vakuumverdampfer auf 150 A, als Reaktivgas wird Stickstoff mit einem Gasfluß von 800sccm eingelassen und die Substrat-Vorspannung wird auf 90V erhöht. Die Rotationsgeschwindigkeit des Drehkorbes wird derart gewählt, daß sich eine Vielzahl von Einzelschichten mit einer Dicke von ca. 0,008µm abscheiden. Nach ca. 15 min wird eine Gesamtschichtdicke von 1µm erreicht. Die Substrattemperatur beträgt 190°C. Sie liegt damit um ca. 15°C unterhalb der maximalen Temperatur bei der zweiten Temperung.

Abschließend wird zur Ausbildung einer ZrCN-Deckschicht, unter Beibehaltung der bisherigen Bedingungen, C₂H₂ als weiteres Reaktivgas zur Gasatmosphäre mit einem Gasfluß von 20 sccm zugemischt. Nach einer Abkühlzeit von ca. 15 min können die Substrate aus der Beschichtungskammer entnommen und an die Atmosphäre gebracht werden.

## Patentansprüche

1. Verfahren zur Herstellung einer haftfesten und korrosionsbeständigen Hartstoffschicht auf einem Substrat, welches eine galvanisch aufgebrachte Nickel-Chrom-Beschichtung aufweist, bei dem die Hartstoffschicht mit einem plasmagestützten physikalischen Vakuumbeschichtungsverfahren abgeschieden wird, **dadurch gekennzeichnet,** daß als Nickel-Chrom-Beschichtung zuerst eine Nickelschicht mit einer Dicke von 13 bis 20µm und darauf eine Chromschicht mit einer Dicke von 0,2 bis 0,3µm abgeschieden wird, daß die Substrate mit der Nickel-Chrom-Beschichtung nach einer Spül- und Trocknungsbehandlung im Vakuum in einer ersten Temperung aufgeheizt werden bis die Substrate sowie alle Einbauten einschließlich der Wandung der Beschichtungskammer eine Temperatur zwischen 75 und 150°C aufweisen und vorhandene Wasserkondensate von den Oberflächen abgedampft sind, daß die Substrate anschließend ohne Unterbrechung des Vakuums in einer zweiten Temperung auf eine für das Grundmaterial der Substrate maximal zulässigen Temperatur aufgeheizt werden bis mindestens aus der oberflächennahen Zone der galvanischen aufgebrachten Chromschicht der eingeschlossene Wasserstoff ausgetrieben ist, daß danach die Temperatur der Substrate abgesenkt wird und auch in der nächsten Folge unterhalb der maximalen Temperatur bei der zweiten Temperung gehalten wird, daß die Substrate einer Lonenbeschußreinigung unterzogen werden bis vorhandene Verunreinigungen im wesentlichen und Oxidschichten bis auf Reststrukturen beseitigt sind, daß darauf mittels eines plasmagestützten physikalischen Vakuumbeschichtungsverfahrens eine Metallschicht mit einer Dicke von 0,05 bis 1µm mit geringer Geschwindigkeit abgeschieden wird und daß abschließend mittels des gleichen Vakuumbeschichtungsverfahrens mit hoher Geschwindigkeit und hoher Substrat-Vorspannung mindestens eine korrosionsbeständige Hartstoffschicht mit einer Dicke zwischen 0,5 bis 2µm abgeschieden wird, wobei die Temperatur der Substratoberfläche gegenüber der Temperatur bei der Ionenbeschußreinigung angehoben wird aber unterhalb der Temperatur der zweiten Temperung gehalten wird.

2. Verfahren nach Anspruch 1, **dadurch gekennzeichnet,** daß die erste Temperung mit einem Heizverfahren durchgeführt wird, welches mindestens teilweise Wärmestrahlung nutzt.

3. Verfahren nach Anspruch 1 oder 2, **dadurch gekennzeichnet,** daß die zweite Temperung in einem Plasma mittels Elektronenbeschuß durchgeführt wird.

4. Verfahren nach einem der Ansprüche 1 bis 3, **dadurch gekennzeichnet,** daß das die Ionenbeschußreinigung über einen ersten Zeitraum mit kontinuierlich ansteigender Substratvorspannung und danach über einen zweiten Zeitraum mit einer konstanten Substratvorspannung durchgeführt wird.

5. Verfahren nach einem der Ansprüche 1 bis 4, **dadurch gekennzeichnet,** daß das Plasma mittels einer Niedervolt-Bogenentladung, vorzugsweise einer Hohlkathoden-Bogenentladung, erzeugt wird.

6. Verfahren nach einem der Ansprüche 1 bis 5, **dadurch gekennzeichnet,** daß als plasmagestütztes physikalisches Vakuumbeschichtungsverfahren das Verfahren mit kathodischer Vakuumbogenverdampfung durchgeführt wird.

7. Verfahren nach einem der Ansprüche 1 bis 6, **dadurch gekennzeichnet,** daß als Reststruktur der Oxidschichten eine Menge aufrechterhalten wird, die geeignet ist, flächendeckend als haftvermittelnde Kristallisationspunkte bei der anschließend folgenden Abscheidung der Metallschicht zu wirken.

8. Verfahren nach einem der Ansprüche 1 bis 7, **dadurch gekennzeichnet,** daß die Hartstoffschicht durch Abscheidung in einer Atmosphäre spezifischer Reaktivgas-Komponenten dekorativ gefärbt wird.

9. Verfahren nach einem der Ansprüche 1 bis 8, **dadurch gekennzeichnet,** daß während der Abscheidung der Hartstoffschicht die Reaktivgaszusammensetzung kontinuierlich oder diskontinuierlich geändert wird.

10. Haftfeste korrosionsbeständige Hartstoffbeschichtung auf einem Substrat mit einem aufeinanderfolgenden Schichtaufbau bestehend aus 13 bis 20 µm Nickel, 0,2 bis 0,3 µm Chrom, 0,05 bis 1µm Metall und 0,5 bis 2 µm Hartstoffschicht.

11. Haftfeste korrosionsbeständige Hartstoffbeschichtung nach Anspruch 10, **dadurch gekennzeichnet,** daß die Metallschicht aus Zirkon besteht.

12. Haftfeste korrosionsbeständige Hartstoffbeschichtung nach Anspruch 10 oder 11, **dadurch gekennzeichnet,** daß die Hartstoffschicht ein Nitrid, Carbid oder Carbonitrid des Metalles der Metallschicht ist.
